# FASCICULE DE BREVET EUROPEEN

(11) **EP 1 179 760 B1**
(45) Date de publication et mention de la délivrance du brevet: **31.08.2005**
(21) Numéro de dépôt: 01401810.5
(22) Date de dépôt: 04.07.2001
(51) Int. Cl.: G05B 19/42, H04L 29/06, H04L 12/40

(54) **Bus interne automate supportant le protocole TCP/IP**
Automatisiertes internes Bussystem zur Unterstützung des TCP/IP Protokolls
An automation internal bus supporting the TCP/IP protocol

(30) Priorité: 13.07.2000 FR 0009803
(43) Date de publication de la demande: 13.02.2002
(73) Titulaire: Schneider Automation, 06560 Valbonne (FR)
(72) Inventeur: Godicke, Thomas, 06560 Valbonne (FR); Gorisse, Francois, Villa l'Andalouse, 06250 Mougins (FR); Genin, Jean-Jacques, 06100 Nice (FR)

(56) Documents cités:
- EP-A- 0 977 412
- EP-A- 0 992 867
- US-A- 5 177 737
- US-A- 5 710 708

## Description

La présente invention concerne un système de communication dans un automate programmable permettant de réaliser, sur le bus de communication interne de l'automate programmable, des échanges conformes au protocole TCP/IP. L'invention concerne également un automate programmable susceptible de mettre en oeuvre un tel système de communication. Ce système peut s'appliquer à tout process automatisé et notamment au domaine des automatismes industriels, des automatismes du bâtiment ou du contrôle/commande des réseaux électriques de distribution.

Le protocole standard IP (Internet Protocol) définit un protocole d'interconnexion entre différents réseaux de communication, au niveau de la couche réseau. Le protocole standard TCP (Transport Control Protocol) définit, au niveau de la couche transport, un mécanisme de transport des données robuste et fiable garantissant un contrôle des données de bout en bout. Ces deux protocoles sont utilisés dans des réseaux globaux de type Internet, Intranet ou Extranet, qui seront regroupés dans le présent exposé sous le terme "réseau TCP/IP".

Un automate programmable modulaire pilotant un process à automatiser comporte au moins un module unité centrale dans lequel s'exécute un programme application pour le contrôle/commande du process. L'automate programmable peut également comporter, si besoin, un ou plusieurs modules métier dotés eux aussi d'une unité de traitement pour assurer des fonctions d'automatisme (pesage, régulation, positionnement, communication,...) ainsi que d'autres modules tels que des modules d'entrées/sorties (digitales ou analogiques). Dans la suite de l'exposé, le terme "module intelligent" représentera indifféremment un module unité centrale, un module métier ou tout module doté d'une unité de traitement propre. Les modules d'un automate programmable sont reliés entre eux par un bus de communication interne, qui est généralement un bus de type fond de panier. Les protocoles utilisés sur un bus de communication interne sont habituellement des protocoles propriétaires.

Dans un automate programmable, il est connu de disposer d'un module de communication, appelé ci-après module réseau, connecté au bus de communication interne de l'automate et relié à un réseau TCP/IP. Un tel module réseau peut alors servir de passerelle entre d'un côté le protocole TCP/IP utilisé sur le réseau TCP/IP et de l'autre côté un ou plusieurs protocoles implantés sur le bus de communication

Cependant, dans ces conditions, il n'est pas possible de maintenir les caractéristiques d'une communication selon le protocole TCP/IP de bout en bout entre deux entités communiquant entre elles. En effet, la passerelle que constitue un module réseau coupe le flux de données de TCP et n'assure pas non plus la transparence de IP. On perd ainsi les avantages en performance, en fiabilité et en transparence que procurent le protocole TCP/IP. Or, il serait avantageux de pouvoir bénéficier de ce protocole standard pour des communications à partir ou à destination de modules intelligents d'un automate programmable.

Le document EP0977412 décrit un procédé d'attribution d'adresses entre des unités d'un système de conduite industriel. Chaque unité est constituée d'un ordinateur et peut se voir attribuer une adresse IP individuelle pour communiquer sur un réseau local externe, selon les protocoles IP, TCP ou UDP. Notre demande concerne au contraire un système de communication entre modules intelligents à l'intérieur d'un automate programmable modulaire assimilable à une seule unité programmable d'exploitation.

Le document US5710708 concerne un système de contrôle pour une pluralité de machines de filature. Le système comprend une architecture de communication à plusieurs niveaux. Un même protocole de communication, tel que le protocole TCP/IP, peut être utilisé dans les différents niveaux de l'architecture. Néanmoins, ce document ne décrit pas que, pour échanger des informations conformes au protocole TCP/IP sur le bus de communication interne, un module intelligent d'un automate programmable comporte une adresse IP propre et une pile TCP/IP exécutable par l'unité de traitement du module intelligent.

Le but de l'invention est donc de proposer à des modules intelligents connectés au bus de communication interne d'un automate programmable un accès direct au protocole TCP/IP pour effectuer des échanges entre eux et des échanges sur un réseau TCP/IP, sans avoir recours à une passerelle au niveau de la couche application qui peut se révéler coûteuse. De plus, grâce au protocole TCP/IP, le module unité centrale ou des modules métier d'un automate programmable pourront directement utiliser les protocoles et les architectures du WEB comme par exemple les standards UDP, HTTP, XML, WAP, FTP, SMTP, SNMP, DHCP, DNS, etc...

Pour cela, l'invention décrit un système de communication dans un automate programmable modulaire qui comprend plusieurs modules intelligents dotés d'une unité de traitement propre et qui comprend un bus de communication interne permettant de faire communiquer les modules de l'automate programmable entre eux. Le système de communication se caractérise par le fait que, pour communiquer conformément au protocole de communication TCP/IP sur le bus de communication interne, un module intelligent de l'automate programmable comporte une adresse IP propre et une pile TCP/IP exécutable par l'unité de traitement du module intelligent, et par le fait que le bus de communication interne comporte plusieurs canaux de communication séparés permettant de faire circuler simultanément des trames conformes au protocole TCP/IP avec des trames conformes à d'autres protocoles.

De plus, un automate programmable modulaire peut comporter au moins un module réseau, raccordé à un réseau TCP/IP externe, permettant à un coupleur intelligent de l'automate programmable de réaliser directement sur le réseau TCP/IP des échanges d'informations conformes au protocole de communication TCP/IP, via le bus de communication interne.

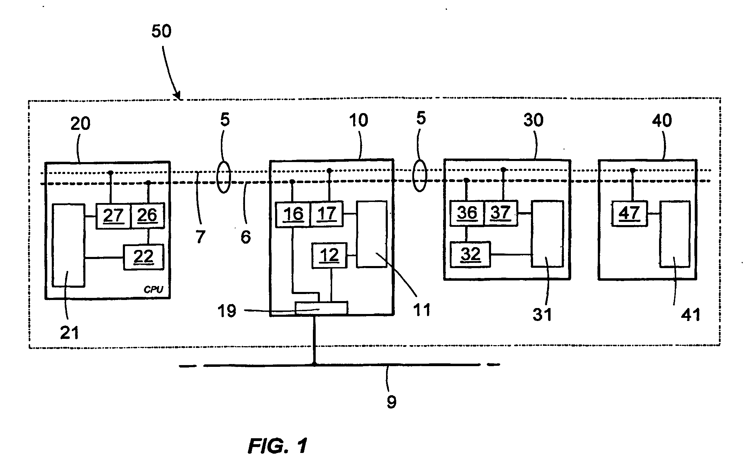

Le module réseau 10 possède une unité de traitement propre 11 et est connecté à un réseau TCP/IP externe 9 grâce à un driver d'accès 19 pour la couche liaison et à un adaptateur au médium du réseau TCP/IP 9 (non schématisé en figure 1) pour la couche physique. De façon préférentielle, le réseau TCP/IP 9 s'appuie sur le standard Ethernet pour les couches physique et liaison, de sorte que le driver d'accès 19 gère notamment un adressage MAC (Media Access Control) du coupleur réseau 10, conforme à la couche liaison MAC préconisée dans la norme IEEE802.3 ou dans la norme RFC894. Comme indiqué en début de l'exposé, le réseau TCP/IP 9 utilise le protocole TCP/IP au niveau des couches réseau et transport. Dans l'exemple de la figure 1, le module unité centrale 20 et le module métier 30 sont des modules intelligents susceptibles de communiquer sur le réseau TCP/IP 9.

Le bus de communication interne 5 doit disposer de la possibilité de faire circuler des trames correspondant à des flux de communication différents : en plus d'un flux IP de communication lié aux trames du protocole TCP/IP, il existe en effet sur le bus de communication 5 un flux IO de données des entrées/sorties de l'automate et éventuellement d'autres flux de données liés par exemple à une messagerie propriétaire. En conséquence, ces flux sont acheminés dans le bus de communication 5 sur des canaux de communication distincts qui doivent travailler au niveau de la couche liaison et être capable de véhiculer n'importe quelle trame. Sur la figure 1, sont représentés un canal de communication 6 pour le flux IP et un canal de communication 7 pour le flux IO d'entrées/sorties.

Pour se raccorder au bus de communication 5, les modules 10,20,30,40 comportent des drivers d'accès au bus qui gèrent la couche physique et la couche liaison du bus de communication et qui doivent être spécifiques à chaque canal de communication. Pour le canal de communication 7 correspondant au flux IO, les modules 10,20,30,40 possèdent un driver d'accès 17,27,37,47. Pour le canal de communication 6 correspondant au flux IP, les modules 10,20,30 possèdent un driver d'accès 16,26,36. Le module d'entrées/sorties 40 n'ayant pas d'accès au réseau TCP/IP 9, il ne dispose pas de driver d'accès au flux IP.

Le système de communication permet à des modules intelligents 20,30 de communiquer par le protocole TCP/IP soit entre eux, soit directement sur un réseau TCP/IP 9 raccordé à un module réseau 10. Pour cela, les modules intelligents 20,30 comportent chacun une pile TCP/IP 22,32 (stack TCP/IP) exécutable par l'unité de traitement 21,31 du module intelligent 20,30. Cette pile TCP/IP 22,32 est reliée au driver d'accès 26,36 du flux IP et gère les couches réseau et transport du protocole TCP/IP. Chaque module intelligent 20,30 doit également posséder son adresse IP propre.

A l'intérieur d'un automate programmable 50, une communication directe par TCP/IP entre modules intelligents peut être intéressante par exemple lorsqu'un des modules est un coupleur IHM (Interface Homme-Machine) qui se présente sous la forme d'un navigateur HTTP et qui peut de façon native échanger des informations selon le protocole TCP/IP. Il pourra alors communiquer avec des modules intelligents de l'automate sans avoir besoin de développer d'autres protocoles.

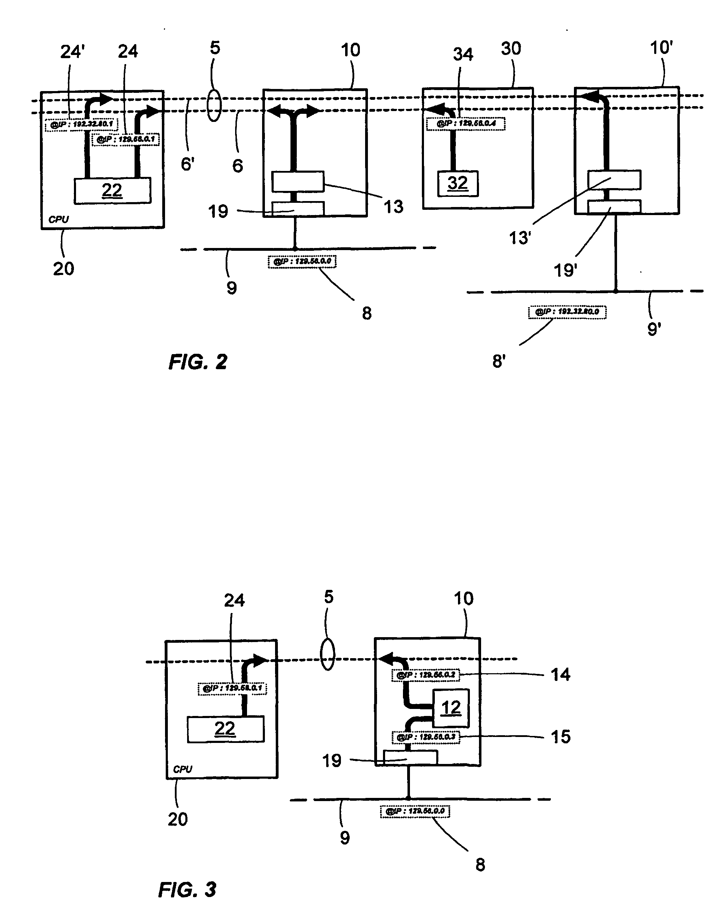

Deux modes de fonctionnement du système de communication vont maintenant être détaillés, en référence aux figures 2 et 3 :
- Dans un premier mode de fonctionnement, appelé fonctionnement A et détaillé en figure 2, le bus de communication 5 n'est qu'un prolongement du réseau TCP/IP 9 sur lequel le module réseau 10 est connecté. Dans ce cas, celui-ci ne sert qu'à router les trames IP émises ou destinées à un module intelligent 20,30. Le module réseau 10 n'a alors pas besoin de comporter sa propre pile TCP/IP, sauf s'il se comporte lui-même comme un module intelligent capable de posséder des applications WEB.
   Pour qu'un module intelligent 20,30 de l'automate accède directement au réseau TCP/IP 9 d'un module réseau 10, il faut que :
   - la pile TCP/IP 22,32 du module intelligent 20,30 soit capable d'émettre et de recevoir des trames ayant une encapsulation conforme à la couche liaison (couche MAC) du réseau TCP/IP 9,
   - chaque module intelligent 20,30 possède une table de routage IP pour router les trames émises par lui vers le (ou les) module(s) réseau(x) 10,10' de l'automate 50,
   - le module réseau 10 possède des moyens de filtrage et de redirection 13 des trames IP en provenance du réseau TCP/IP 9 en fonction de l'adresse IP 24,34 des modules intelligents 20,30, permettant de n'envoyer vers ces modules 20,30 que les trames comportant leur adresse IP. Ce filtrage est possible grâce à une table de mémorisation de l'adresse IP des modules intelligents 20,30 de l'automate 50 susceptibles d'accéder au réseau TCP/IP 9, cette table de mémorisation étant stockée dans le module réseau 10.
- Dans un deuxième mode de fonctionnement, appelé fonctionnement B et détaillé en figure 3, le bus de communication 5 est vu comme un sous-réseau IP à part entière du réseau TCP/IP 9 sur lequel le module réseau 10 est connecté. Dans ce cas, le module réseau 10 comporte deux attachements IP matérialisés par une première adresse IP 15 correspondant au réseau TCP/IP 9 et par une deuxième adresse IP 14 correspondant au bus de communication 5 de l'automate 50. Le module réseau 10 possède aussi obligatoirement sa propre pile TCP/IP 12 exécutable dans le module réseau 10 permettant de faire le routage des trames entre les deux attachements IP.
   En fonction de l'adresse du sous-réseau IP sur le bus de communication 5, on peut choisir le niveau de visibilité d'un module sur le réseau TCP/IP 9. Si on veut que le module soit vu par l'Internet sans mise à jour de routeur externe, il faut que le bus de communication 5 ait un adressage comportant un même numéro de sous-réseau IP que le réseau TCP/IP 9 du module réseau 10, comme le montre la figure 3. En plus, celui-ci doit agir comme un proxy serveur pour un proxy client se trouvant sur le bus de communication 5. Par rapport au mode de fonctionnement A, c'est le coupleur qui répond à une requête de reconnaissance d'adresse MAC (requête ARP sur Ethernet).

Comme indiqué en figure 2, un même automate programmable peut comporter plusieurs modules réseau 10,10' chacun connecté à un réseau TCP/IP 9,9' différent possédant chacun un numéro IP de réseau 8,8'. Dans ce cas, les flux IP générés par chaque réseau TCP/IP 9,9' sont acheminés par des canaux séparés 6,6' sur le bus de communication 5. Pour pouvoir se connecter à ces différents réseaux Internet arrivant sur l'automate 50, un module intelligent 20 doit alors posséder une adresse IP spécifique 24,24' respectivement pour chaque réseau TCP/IP 9,9'.

Compte tenu du fait que, grâce à l'invention, un module intelligent 20,30 peut être directement connecté sur l'Internet, les aspects de sécurité sont importants. Un premier niveau de sécurité est normalement assuré par un coupe-feu Intranet quand l'automate 50 est raccordé à un réseau de type Intranet 9. Néanmoins, si l'on souhaite mieux contrôler l'accès aux modules intelligents, il existe plusieurs possibilités : on peut rajouter dans le module réseau 10 un filtrage supplémentaire des trames IP, on peut faire un contrôle des connexions rentrantes au-dessus de la couche TCP et on peut aussi renoncer au comportement proxy serveur du module réseau 10 pour éviter qu'un module intelligent 20,30 soit vu automatiquement par l'extérieur sans configuration de routeur externe, dans les fonctionnements A et B. Par ailleurs, ces deux fonctionnements A et B sont compatibles avec la norme RFC925 et ils évitent la mise à jour de tables de routage dans un réseau existant.

Le système de communication décrit dans la présente invention peut être utilisé par un programme application d'un automate programmable pour communiquer des données de synchronisation, de contrôle, de commande ou toute autre information nécessitant la qualité des services offerts par les protocoles de la famille TCP/IP. Par ailleurs, une connexion aisée au monde de l'Internet et du WEB est un avantage majeur par rapport aux protocoles propriétaires. A l'intérieur d'un tel automate programmable, il est ainsi possible de développer un module intelligent (de type PC par exemple) équipé d'un système d'exploitation et d'un navigateur Internet du commerce afin de réaliser le dialogue opérateur homme machine. Utiliser le protocole TCP/IP dans un bus de communication automate est aussi une voie privilégiée pour normaliser les échanges de donnée internes à un automate programmable, cette normalisation facilitant une interopérabilité dans un environnement hétérogène.

De même, il est possible de véhiculer des données auxquelles les automates programmables ne sont pas habituellement utilisés comme le son ou la vidéo, ces informations pouvant être exploitées par l'application elle-même (un module de capture vidéo relié à un module de traitement vidéo) ou pouvant servir à des applications externes et aux services liés à l'automatisme (par exemple télémaintenance d'une installation d'automatisme).

Les données échangées peuvent également être du code programme. Ces programmes peuvent être applicatifs pour modifier le comportement d'un module, lui ajouter des fonctionnalités, mettre à jour une version logicielle, corriger une anomalie, l'espionner lors des phases de développement et permettre des services plus précis en télémaintenance. Ce mécanisme permet d'offrir ainsi au monde de l'automatisme les bases d'une architecture distribuée de traitement.

Le système de communication décrit dans la présente invention peut être utilisé par un programme application d'un automate programmable pour communiquer des données de synchronisation, de contrôle, de commande ou toute autre information nécessitant la qualité des services offerts par les protocoles de la famille TCP/IP. Par ailleurs, une connexion aisée au monde de l'Internet et du WEB est un avantage majeur par rapport aux protocoles propriétaires. A l'intérieur d'un tel automate programmable, il est ainsi possible de développer un module intelligent (de type PC par exemple) équipé d'un système d'exploitation et d'un navigateur Internet du commerce afin de réaliser le dialogue opérateur homme machine. Utiliser le protocole TCP/IP dans un bus de communication automate est aussi une voie privilégiée pour normaliser les échanges de donnée internes à un automate programmable, cette normalisation facilitant une interopérabilité dans un environnement hétérogène.

De même, il est possible de véhiculer des données auxquelles les automates programmables ne sont pas habituellement utilisés comme le son ou la vidéo, ces informations pouvant être exploitées par l'application elle-même (un module de capture vidéo relié à un module de traitement vidéo) ou pouvant servir à des applications externes et aux services liés à l'automatisme (par exemple télémaintenance d'une installation d'automatisme).

Les données échangées peuvent également être du code programme. Ces programmes peuvent être applicatifs pour modifier le comportement d'un module, lui ajouter des fonctionnalités, mettre à jour une version logicielle, corriger une anomalie, l'espionner lors des phases de développement et permettre des services plus précis en télémaintenance. Ce mécanisme permet d'offrir ainsi au monde de l'automatisme les bases d'une architecture distribuée de traitement.

## Revendications

1. Système de communication dans un automate programmable modulaire (50) qui comprend plusieurs modules intelligents (20,30) dotés d'une unité de traitement propre (21,31) et qui comprend un bus de communication interne (5) permettant de faire communiquer les modules de l'automate programmable (50) entre eux, **caractérisé par le fait que**, pour communiquer conformément au protocole de communication TCP/IP sur le bus de communication interne (5), un module intelligent (20,30) de l'automate programmable (50) comporte une adresse IP propre (24,34) et une pile TCP/IP (22,32) exécutable par l'unité de traitement (21,31) du module intelligent (20,30), et **par le fait que** le bus de communication interne (5) comporte plusieurs canaux de communication (6,7) séparés permettant de faire circuler simultanément des trames conformes au protocole TCP/IP avec des trames conformes à d'autres protocoles.

2. Système de communication selon la revendication 1, **caractérisé par le fait que** l'automate programmable modulaire (50) comprend au moins un module réseau (10), raccordé à un réseau TCP/IP externe (9), permettant à un coupleur intelligent (20,30) de l'automate programmable (50) de réaliser directement des échanges d'informations conformes au protocole de communication TCP/IP sur le réseau TCP/IP (9), via le bus de communication interne (5).

3. Système de communication selon la revendication 2, **caractérisé par le fait que** l'automate programmable (50) comporte plusieurs modules réseau (10,10') raccordés à plusieurs réseaux Internet (9,9'), chaque module réseau (10,10') utilisant un canal de communication différent (6,6') pour faire circuler simultanément des trames sur le bus de communication interne (5).

4. Système de communication selon la revendication 3, **caractérisé par le fait que**, pour accéder directement à plusieurs réseaux Internet (9,9'), un module intelligent (20) de l'automate programmable (50) comporte plusieurs adresses IP respectives (24,24').

5. Système de communication selon la revendication 2, **caractérisé par le fait que**, dans l'automate programmable (50), un module réseau (10) connecté à un réseau TCP/IP (9) comporte :
- un driver d'accès (19) à la couche liaison du réseau TCP/IP (9),
- une table de mémorisation de l'adresse IP des différents modules intelligents (20,30) de l'automate (50) susceptibles d'accéder au réseau TCP/IP (9),
- des moyens de filtrage et de redirection (13) des trames IP en provenance du réseau TCP/IP (9) en fonction de l'adresse IP (24,34) des modules intelligents correspondants.

6. Système de communication selon la revendication 5, **caractérisé par le fait que** la pile TCP/IP (22,32) d'un module intelligent (20,30) est susceptible d'émettre et de recevoir des trames ayant une encapsulation conforme à la couche liaison du réseau TCP/IP (9) et **par le fait que** le module intelligent (20,30) possède une table de routage IP pour router les trames émises par le module intelligent vers le module réseau (10).

7. Système de communication selon la revendication 2, **caractérisé par le fait qu'**un module réseau (10) connecté à un réseau TCP/IP (9) comporte :
- un driver d'accès (19) à la couche liaison du réseau TCP/IP (9),
- deux attachements IP matérialisés par une première adresse IP (15) correspondant au réseau TCP/IP (9) et par une deuxième adresse IP (14) correspondant au bus de communication interne (5),
- une pile TCP/IP (12) exécutable dans le module réseau (10), permettant de faire le routage des trames entre les deux attachements IP.

8. Système de communication selon la revendication 2, **caractérisé par le fait que** la couche liaison du réseau TCP/IP (9) est la couche MAC préconisée dans le standard Ethernet.

## Patentansprüche

1. Kommunikationssystem in einer modularen programmierbaren Steuerung (50), die mehrere intelligente Module (20, 30) umfasst, die mit einer eigenen Bearbeitungseinheit (21, 31) ausgestattet sind und das einen internen Kommunikationsbus (5) umfasst, der es erlaubt, die Module der programmierbaren Steuerung (50) miteinander kommunizieren zu lassen, **dadurch gekennzeichnet dass**, um gemäß des Kommunikationsprotokolls TCP/IP am internen Kommunikationsbus (5) zu kommunizieren, ein intelligentes Modul (20, 30) der programmierbaren Steuerung (50) eine eigene IP Adresse (24, 34) und einen TCP/IP Stapel (22, 32) umfasst, der von einer Bearbeitungseinheit (21, 31) des intelligenten Moduls (20, 30) ausführbar ist, und **dadurch gekennzeichnet, dass** der interne Kommunikationsbus (5) mehrere getrennte Kommunikationskanäle (6, 7) umfasst, die es erlauben, gleichzeitig Rahmen, die dem TCP/IP Protokoll entsprechen, mit Rahmen, die anderen Protokollen entsprechen, zirkulieren zu lassen.

2. Kommunikationssystem nach Anspruch 1, **dadurch gekennzeichnet, dass** die modulare programmierbare Steuerung(50) mindestens ein Netzmodul (10) umfasst, das an ein externes TCP/IP Netz (9) angeschlossen ist, das es einem intelligenten Koppler (20, 30) der programmierbaren Steuerung (50) erlaubt, direkt am TCP/IP Netz Informationsaustausche zu realisieren, die dem TCP/IP Kommunikationsprotokoll entsprechen, und dies über den internen Kommunikationsbus (5).

3. Kommunikationssystem nach Anspruch 2, **dadurch gekennzeichnet, dass** die programmierbare Steuerung (50) mehrere Netzmodule (10, 10') umfasst, die an mehrere Internetnetze (9, 9') angeschlossen sind, wobei jedes Netzmodul (10, 10') einen anderen Kommunikationskanal (6, 6') verwendet, um gleichzeitig Rahmen am internen Kommunikationsbus (5) zirkulieren zu lassen.

4. Kommunikationssystem nach Anspruch 3, **dadurch gekennzeichnet, dass**, um direkt auf mehrere Internetnetze (9, 9') zuzugreifen, ein intelligentes Modul (20) der programmierbaren Steuerung (50) mehrere entsprechende IP Adressen (24, 24') aufweist.

5. Kommunikationssystem nach Anspruch 2, **dadurch gekennzeichnet, dass** in der programmierbaren Steuerung (50), ein Netzmodul (10), das an ein TCP/IP Netz (9) angeschlossen ist, Folgendes umfasst:
- einen Zugangsdriver (19) zur Verbindungsschicht des TCP/IP Netzes (9),
- eine Speichertabelle der IP Adresse der verschiedenen intelligenten Modulen (20, 30) der Steuerung (50), die auf das TCP/IP Netz (9) zugreifen können,
- Filtrier- und Umleitungsmittel (13) der IP Rahmen, die vom TCP/IP Netz (9) stammen, und dies in Abhängigkeit von der IP Adresse (24, 34) der entsprechenden intelligenten Module.

6. Kommunikationssystem nach Anspruch 5, **dadurch gekennzeichnet, dass** der TCP/IP Stapel (22, 32) eines intelligenten Moduls (20, 30) Rahmen senden und empfangen kann, die eine Einkapselung aufweisen, die der Verbindungsschicht des TCP/IP Netzes (9) entspricht, und **dadurch gekennzeichnet, dass** das intelligente Modul (20, 30) über eine IP Routingtabelle verfügt, um die die vom intelligenten Modul zum Netzmodul (10) gesendeten Rahmen zu leiten.

7. Kommunikationssystem nach Anspruch 2, **dadurch gekennzeichnet, dass** ein Netzmodul (10), das an ein TCP/IP Netz (9) angeschlossen ist, Folgendes umfasst:
- einen Zugangsdriver (19) zur Verbindungsschicht des TCP/IP Netzes (9),
- zwei IP Anschlüsse, die durch eine erste IP Adresse (15), die dem TCP/IP Netz (9) entspricht und durch eine zweite IP Adresse (14), die dem internen Kommunikationsbus (5) entspricht, materialisiert sind,
- ein TCP/IP Stapel (12), der im Netzmodul (10) ausführbar ist, der es erlaubt, das Routing der Rahmen zwischen den beiden IP Anschlüssen zu realisieren.

8. Kommunikationssystem nach Anspruch 2, **dadurch gekennzeichnet, dass** die Verbindungsschicht des TCP/IP Netzes (9) die MAC Schicht ist, die im Ethernet Standard vorgeschrieben wird.

## Claims

1. Communications system in a modular programmable controller (50) that includes several smart modules (20,30) equipped with its own processing unit (21,31) and which comprises an internal communications bus (5) that allows inter-connecting the modules of the programmable controller (50), **characterised in that** in order to communicate in compliance with the TCP/IP communications protocol over the internal communications bus (5), an intelligent module (20,30) of the programmable controller (50) includes its own IP address (24,34) and a TCP/IP stack (22,32) that can be executed by the processing unit (21,31) of the smart module (20,30), and **in that** the internal communications bus (5) includes several separate communications channels (6,7) that allow the simultaneous flow of the frames complying with the TCP/IP protocol together with frames complying with other protocols.

2. Communications system according to claim 1, **characterised in that** a modular programmable controller (50) comprises at least one network module (10), connected to an external TCP/IP network (9), allowing a smart coupler (20,30) of the programmable controller (50) to directly perform data exchanges in compliance with the TCP/IP communications protocol over the TCP/IP network (9), via the internal communications bus (5).

3. Communications system according to claim 2, **characterised in that** the programmable controller (50) includes several network modules (10,10') connected to several Internet networks (9,9'); each network module (10,10') uses a different communications channel (6,6') for the simultaneous flow of frames over the internal communications bus (5).

4. Communications system according to claim 3, **characterised in that** in order to directly access several Internet networks (9,9'), a smart module (20) of the programmable controller (50) includes several respective IP address (24,24').

5. Communications system according to claim 2, **characterised in that**, in the programmable controller (50), a network module (10) connected to the TCP/IP network (9) includes:
- a driver (19) for accessing the link layer of the TCP/IP network (9),
- a table for storing the IP address of the different smart modules (20,30) of the controller (50), capable of accessing the TCP/IP network (9),
- means for filtering and redirecting (13) the IP frames from the TCP/IP network (9) according to the IP address (24,34) of the corresponding smart modules.

6. Communications system according to claim 5, **characterised in that** the TCP/IP stack (22,32) of a smart module (20,30) is capable of transmitting and receiving frames with an encapsulation complying with the link layer of the TCP/IP network (9), and **in that** the smart module (20,30) has an IP routing table for routing the frames transmitted by the smart module to the network module (10).

7. Communications system according to claim 2, **characterised in that** a network module (10) connected to a TCP/IP network (9) includes:
- a driver (19) for accessing the link layer of the TCP/IP network (9),
- two IP attachments materialised by a first IP address (15) corresponding to the TCP/IP network (9) and by a second IP address (14) corresponding to the internal communications bus (5),
- a TCP/IP stack (12) that can be executed in the network module (10), allowing the frames to be routed between both IP attachments.

8. Communications system according to claim 2, **characterised in that** the link layer of the TCP/IP network (9) is the recommended MAC layer in the Ethernet standard.
